# EUROPEAN PATENT APPLICATION

(11) **EP 2 169 729 A1**
(43) Date of publication of application: **31.03.2010**
(21) Application number: 08776996.4
(22) Date of filing: 29.05.2008
(51) Int. Cl.: H01L 31/075, H01L 27/142

(54) **THIN FILM SOLAR CELL MODULE**

(30) Priority: 13.07.2007 JP 2007184664
(71) Applicant: Sharp Kabushiki Kaisha, Osaka-shi Osaka 545-8522 (JP)
(72) Inventor: NASUNO, Yoshiyuki, Osaka-shi, Osaka 545-8522 (JP); SHIMIZU, Akira, Osaka-shi, Osaka 545-8522 (JP)
(74) Representative: Müller - Hoffmann & Partner
(86) International application number: PCT/JP2008/059934
(87) International publication number: WO 2009/011174

(57) **Abstract**

To provide a thin-film solar cell module capable of preventing damage to a cell and a contact line.

A thin-film solar cell module of the present invention has a characteristic that it provides a cell module having a plurality of cell strings bidirectionally connected to each other in parallel, the cell strings each having a plurality of cells connected to each other in series via a contact line, wherein when an output from the cell module is P (W), an output from one of the cell strings is Ps (W), and an area of the contact line is Sc (cm²) under a condition of light source: xenon lamp, irradiance: 100 mW/cm², AM: 1.5, and temperature: 25°C, (P - Ps) / Sc is 10.7 (kW/cm²) or less, Ps is 12 W or less, and P is 385 W or less.

## Description

### TECHNICAL FIELD

The present invention relates to a thin-film solar cell module.

### BACKGROUND ART

In recent years, thin-film photoelectric conversion devices which are formed from gaseous materials by a plasma CVD method receive attention. Examples of such thin-film photoelectric conversion devices include silicon base thin-film photoelectric conversion devices including a silicon base thin-film, thin-film photoelectric conversion devices including CIS (CuInSe₂) compounds or CIGS (Cu(In,Ga) Se₂) compounds, and the like, and development of these devices are accelerated and their quantity of production is increasingly enlarged. A major feature of these photoelectric conversion devices lies in a fact that these devices have potential that cost reduction and higher performance of the photoelectric conversion device can be simultaneously achieved by layering a semiconductor layer or a metal electrode film on a low-cost substrate having a large area with a formation apparatus such as a plasma CVD apparatus or a sputtering apparatus, and then separating and connecting photoelectric conversion devices prepared on the same substrate by laser patterning or the like.

In the meantime, a thin-film photoelectric conversion module having a serial array formed of a plurality of cells connected in series is known (see, for example, Patent Document 1). Patent Document 1 discloses that damage to a cell due to a hotspot phenomenon can be sufficiently prevented by designing a photoelectric conversion device so that a short-circuit current carried by the serial array comes to 600 mA or less under a predetermined condition.
[Patent Document 1] Japanese Unexamined Patent Application Publication No. 2001-68713

### DISCLOSURE OF THE INVENTION

### PROBLEMS TO BE SOLVED BY THE INVENTION

The inventors of the present invention have made intensive studies to find that the method disclosed in Patent Document 1 cannot sufficiently prevent damage to a cell due to a hotspot phenomenon or sufficiently prevent damage to a contact line that electrically connects neighboring cells in some cases.

In view of the above-described situation, the present invention has been achieved to provide a thin-film solar cell module capable of preventing damage to a cell and a contact line.

### MEANS FOR SOLVING THE PROBLEMS AND EFFECTS OF THE INVENTION

A thin-film solar cell module of the present invention has a characteristic that it provides a cell module having a plurality of cell strings bidirectionally connected to each other in parallel, the cell strings each having a plurality of cells connected to each other in series via a contact line, the cells each having a surface electrode, a photoelectric conversion layer, and a back surface electrode stacked in this order, the contact line electrically connecting the surface electrode of one of two neighboring cells of the cells and the back surface electrode of the other, wherein when an output from the cell module is P (W), an output from one of the cell strings is Ps (W), and an area of the contact line is Sc (cm²) under a condition of light source: xenon lamp, irradiance: 100 mW/cm², AM: 1.5, and temperature: 25°C, (P - Ps) / Sc is 10.7 (kW/cm²) or less, Ps is 12 W or less, and P is 385 W or less.

First, the inventors of the present invention assumed that damage to a cell was associated with the output from the cell strings, not the magnitude of the current carried by the cell strings, to come up with an idea that an upper limit should be established for the maximum output of the cell strings. Then, the inventors of the present invention carried out a great number of experiments to find that damage to a cell could be prevented even under an extremely disadvantageous condition by limiting the output from the cell strings to 12 W or less.

In addition, the inventors of the present invention came up with an idea that when only one cell string is in shade and the other cell strings carry out power generation, the generated power may flow into the cell string in shade to damage a contact line that connects two neighboring cells in the cell string in series. Then, the inventors of the present invention carried out a great number of experiments to find that damage to a contact line could be prevented by limiting the power density applied to the contact line, which is defined as (P - Ps) / Sc, to 10.7 (kW/cm²), when P is 385 W or less, to reach completion of the present invention.

Hereinafter, various embodiments of the present invention will be exemplified.
P may be 90 W or more. In this case, damage to a contact line is relatively likely to occur, and therefore it provides greater benefits to apply the present invention.
The contact line may have a width in a range of 40 µm to 200 µm_{.}
The surface electrode may be formed of a transparent conductive film formed of a material containing SnO₂, and the back surface electrode may have a layered structure of a transparent conductive film and a metal film.
The various embodiments shown herein may be combined with one another.

### BRIEF DESCRIPTION OF THE DRAWINGS

FIG. 1 is a plan view illustrating a configuration of a thin-film solar cell module according to an embodiment of the present invention.
FIG. 2 is a sectional view as seen from I-I in FIG. 1.
FIG. 3 (a) is an enlarged view of an area A in FIG. 1; and FIG. 3(b) is a drawing illustrating a contact line taken from FIG. 3 (a).
FIGs. 4 (a) to (c) are drawings for illustrating a term "to be bidirectionally connected to each other in parallel" in a thin-film solar cell module according to an embodiment of the present invention.
FIG. 5 is a plan view illustrating a configuration of a thin-film solar cell module according to another embodiment of the present invention.
FIG. 6 is a plan view illustrating a configuration of a thin-film solar cell module according to another embodiment of the present invention.
FIG. 7 is a sectional view illustrating a structure of a plasma CVD apparatus to be used for production of a thin-film solar cell module according to an embodiment of the present invention.

### DESCRIPTION OF THE REFERENCE NUMERALS

- 1: Thin-film solar cell module
- 1a: Cell module
- 2: Substrate
- 3: Surface electrode
- 5: First photoelectric conversion layer
- 7: Second photoelectric conversion layer
- 9: Third photoelectric conversion layer
- 11: Back surface electrode
- 5a: P-type semiconductor layer
- 5b: Buffer layer
- 5c: I-type amorphous layer
- 5d: N-type semiconductor layer
- 7a: P-type semiconductor layer
- 7b: Buffer layer
- 7c: I-type amorphous layer
- 7d: N-type semiconductor layer
- 9a: P-type semiconductor layer
- 9b: I-type microcrystalline layer
- 9c: N-type semiconductor layer
- 13: Surface electrode division line
- 15: Photoelectric conversion layer division line
- 17: Contact line
- 21: Cell string
- 23: Common electrode
- 25: Parallel division line
- 27: Cell
- 29: Back surface electrode division line
- 31: Blocking diode
- 33: Photoelectric conversion unit
- 101: Film forming chamber
- 102: Cathode electrode
- 103: Anode electrode
- 105: Impedance matching circuit
- 106a: Power introducing line
- 106b: Power introducing line
- 107: Substrate
- 108: Power supply section
- 110: Gas intake section
- 116: Gas exhaust section
- 117: Pressure control valve
- 118: Gas
- 119: Gas exhaust outlet

### BEST MODE FOR CARRYING OUT THE INVENTION

Hereinafter, an embodiment of the present invention will be described by use of the drawings. The contents shown in the drawings and the following description are exemplification, and the scope of the present invention is not limited to the contents shown in the drawings and the following description. Hereinafter, the present invention will be described taking a thin-film solar cell module of a superstrate structure as an example, but the following description is basically also true for a thin-film solar cell module of a substrate structure. However, in the case of the substrate structure, the order of forming a surface electrode, a photoelectric conversion layer, and a back surface electrode is reversed, that is, a back surface electrode, a photoelectric conversion layer, and a surface electrode are formed on a substrate in this order. In the case of the superstrate structure, a side of the substrate is a front surface side, and in the case of the substrate structure, a side of the substrate is a back surface side.
In addition, the present invention will be described taking, as an example, the case where i-type semiconductor layers of a first photoelectric conversion layer and a second photoelectric conversion layer are both amorphous layers, and an i-type semiconductor layer of a third photoelectric conversion layer is a microcrystalline layer, but the following description is basically also true for thin-film solar cell modules of other configurations, for example: a thin-film solar cell module of a configuration in which all the i-type semiconductor layers of the first, second, and third photoelectric conversion layers are amorphous layers or microcrystalline layers; a thin-film solar cell module of a configuration in which the i-type semiconductor layer of the first photoelectric conversion layer is an amorphous layer and the i-type semiconductor layers of the second and third photoelectric conversion layers are both microcrystalline layers; a thin-film solar cell module of a configuration in which one of the second photoelectric conversion layer and the third photoelectric conversion layer or both of the second photoelectric conversion layer and the third photoelectric conversion layer is omitted; and a thin-film solar cell module of a configuration in which another photoelectric conversion layer is further provided at a downstream side with respect to the third photoelectric conversion layer.
Furthermore, the present invention will be described taking, as an example, the case where the p-i-n junction of each photoelectric conversion layer has a p-type semiconductor layer, an i-type semiconductor layer, and an n-type semiconductor layer arranged in this order, but the following description is basically also true for the case where the p-i-n junction of each photoelectric conversion layer has an n-type semiconductor layer, an i-type semiconductor layer, and a p-type semiconductor layer arranged in this order.

### 1. Configuration of thin-film solar cell module

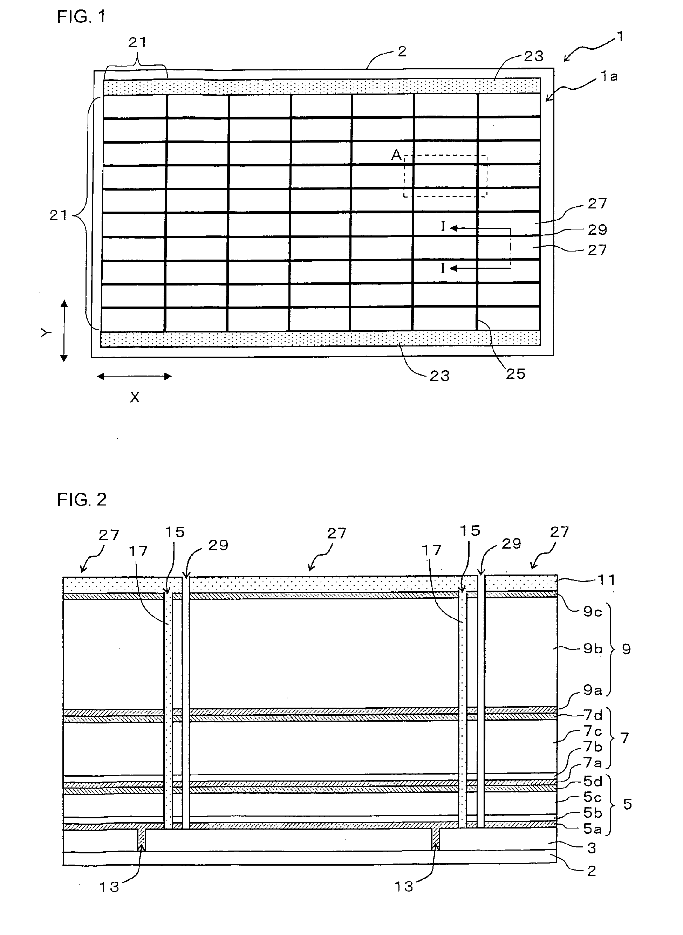

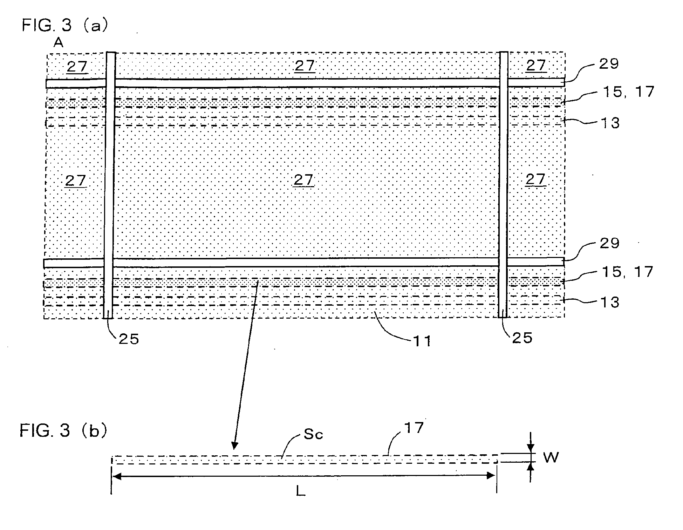

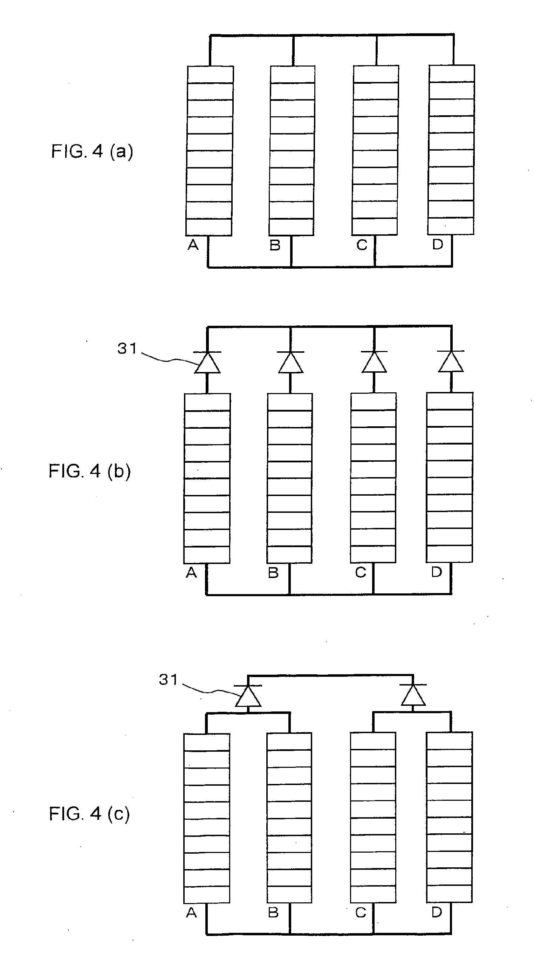

A thin-film solar cell module according to an embodiment of the present invention will be described by use of FIG. 1, FIG. 2, FIGs. 3 (a)(b), and FIGs. 4 (a) to (c). FIG. 1 is a plan view illustrating a configuration of a thin-film solar cell module according to an embodiment of the present invention; FIG. 2 is a sectional view as seen from I-I in FIG. 1; FIG. 3 (a) is an enlarged view of an area A in FIG. 1; FIG. 3 (b) is a drawing illustrating a contact line 17 taken from FIG. 3(a) to show the dimension of the contact line 17; and FIGs. 4 (a) to (c) are drawings for illustrating a term "to be bidirectionally connected to each other in parallel".

A thin-film solar cell module 1 of this embodiment comprises a cell module 1a on a substrate 2. The cell module 1a comprises a plurality of cell strings 21 that are bidirectionally connected to each other in parallel. In the present description, the term "to be bidirectionally connected to each other in parallel" means a situation in which an electric current generated in one cell string 21 can flow into the other cell string 21, and vice versa. When the plurality of cell strings 21 are connected in parallel without interposition of any blocking diode 31 as illustrated in FIG. 4 (a), for example, an electric current generated in a cell string A can flow into a cell string B, and an electric current generated in the cell string B can flow into the cell string A. Such a relationship is satisfied by a combination of any two of the cell strings A to D. Therefore, the cell strings A to D are bidirectionally connected to each other in parallel. On the other hand, when the plurality of cell strings 21 are connected in parallel via the blocking diodes 31 as illustrated in FIG. 4 (b), for example, an electric current generated in the cell string A is blocked by the blocking diode 31 and therefore cannot flow into the cell string B, and an electric current generated in the cell string B is blocked by the blocking diode 31 and therefore cannot flow into the cell string A. Such a relationship is satisfied by a combination of any two of the cell strings A to D. In this case, the cell strings A to D are not bidirectionally connected to each other in parallel. As illustrated in FIG. 4 (c), in addition, there are a group of the cell strings A and B, and a group of the cell strings C and D, in which the cell strings of each group are connected in parallel without interposition of the blocking diode 31, and these two groups are connected in parallel via the blocking diodes 31. In this case, the cell strings A and B are bidirectionally connected to each other in parallel, and the cell strings C and D are bidirectionally connected to each other in parallel. However, the cell strings A and C, for example, are not bidirectionally connected to each other in parallel.
As the substrate 2, a glass substrate, a substrate of a resin such as polyimide, and the like that have heat resistance and a light transmitting property in a plasma CVD forming process can be used.

The plurality of cell strings 21 are separated from each other by parallel division lines 25, and electrically connected to each other in parallel via a common electrode 23. Intervals between two neighboring parallel division lines 25 may or may not be constant. Therefore, the output from the plurality of cell strings 21 may be the same or different from each other.

The cell string 21 comprises a plurality of cells 27 connected to each other in series via a contact line 17. The plurality of cells 27 are separated from each other by a surface electrode division line 13 and a back surface electrode division line 29. Each of the cells 27 has a surface electrode 3, photoelectric conversion layers (first, second, and third photoelectric conversion layers 5, 7, 9), and a back surface electrode 11.

The surface electrode is formed of, for example, a transparent conductive film, preferably a transparent conductive film formed of a material containing SnO₂. The material containing SnO₂ may be SnO₂ itself or a mixture of SnO₂ and another oxide (for example, ITO, which is a mixture of SnO₂ and In₂O₃). The percentage of SnO₂ in the material containing SnO₂ is 3 to 100 wt%, for example, and specifically 3, 5, 10, 20, 30, 40, 50, 60, 70, 80, 90, 95, 99 or 100 wt%, for example. This percentage may be in a range between any two of the numeral values exemplified here, or may be not less than any one of the numeral values.

The first photoelectric conversion layer 5 includes a p-type semiconductor layer 5a, a buffer layer 5b formed of an i-type amorphous layer, an i-type amorphous layer 5c, and an n-type semiconductor layer 5d, stacked in this order. The second photoelectric conversion layer 7 includes a p-type semiconductor layer 7a, a buffer layer 7b formed of an i-type amorphous layer, an i-type amorphous layer 7c, and an n-type semiconductor layer 7d, stacked in this order. The third photoelectric conversion layer 9 includes a p-type semiconductor layer 9a, an i-type microcrystalline layer 9b, and an n-type semiconductor layer 9c, stacked in this order. The buffer layers 5b and 7b may be omitted. The p-type semiconductor layer is doped with p-type impurity atoms such as boron and aluminum, and the n-type semiconductor layer is doped with n-type impurity atoms such as phosphorus. The i-type semiconductor layer may be a semiconductor layer which is entirely undoped, or may be a weak p-type or a weak n-type semiconductor layer including a trace of impurities and having an adequate photoelectric conversion function. In the present description, the term "semiconductor layer" means an amorphous or microcrystalline semiconductor layer, and the terms "amorphous layer" and "microcrystalline layer" mean amorphous semiconductor layer and microcrystalline semiconductor layer, respectively.
The material of each semiconductor layer forming the photoelectric conversion layers is not particularly limited, and examples thereof include a silicon base semiconductor, a CIS(CuInSe₂) compound semiconductor, a CIGS(Cu(In,Ga)Se₂) compound semiconductor, and the like. Hereinafter, the present invention will be described taking, as an example, the case where each semiconductor layer is formed of a silicon base semiconductor. The term "silicon base semiconductor" means amorphous or microcrystalline silicon, or semiconductors (silicon carbide, silicon-germanium, etc.) formed by doping amorphous or microcrystalline silicon with carbon, germanium or other impurities. The term "microcrystalline silicon" means silicon in a state of a mixed phase of crystalline silicon having a small grain size (from several tens to 1000 Å) and amorphous silicon. Such microcrystalline silicon is formed, for example, when a crystal silicon thin film is prepared at low temperature by using a non-equilibrium method such as a plasma CVD method.

The structure and material of the back surface electrode 11 are not particularly limited, but in an example, the back surface electrode 11 has a layered structure of a transparent conductive film and a metal film. The transparent conductive film is formed of SnO₂, ITO, ZnO, or the like. The metal film is formed of a metal such as silver and aluminum. The transparent conductive film and the metal film are formed by a method such as a CVD method, a sputtering method, and a vapor deposition method.

The contact line 17 electrically connects the surface electrode 3 of one of neighboring two cells of the cells 27 and the back surface electrode 11 of the other. The contact line 17 is formed by filling a photoelectric conversion layer division line 15 with an electrical conductor (for example, material of the back surface electrode).

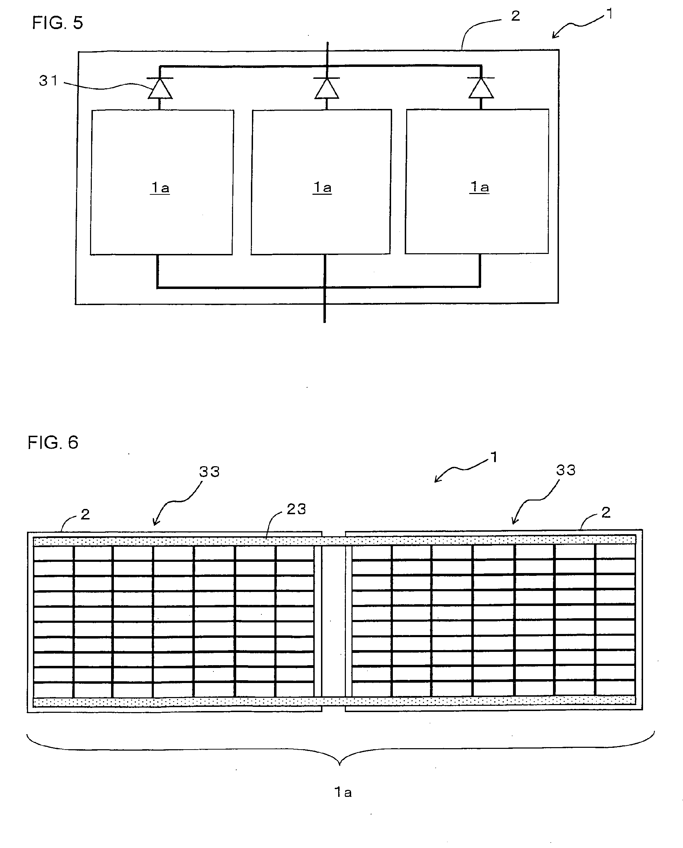

The thin-film solar cell module 1 may comprise one cell module 1a on one piece of the substrate 2 as illustrated in FIG. 1 or may comprise a plurality of cell modules 1a connected in parallel via the blocking diodes 31 on one piece of the substrate 2 as illustrated in FIG. 5. In the latter case, power from one cell module 1a does not flow into another cell module 1a. Therefore, the cell string 21 in one cell module 1a and the cell string 21 in another cell module 1a are not bidirectionally connected to each other in parallel.

In addition, the thin-film solar cell module 1 may comprise a plurality of photoelectric conversion units 33 as illustrated in FIG. 6. Each photoelectric conversion unit 33 has one or a plurality of cell strings on the substrate 2. Further, a plurality of cell strings belonging to different photoelectric conversion units 33 (that is, on different substrates 2) are bidirectionally connected to each other in parallel as illustrated in FIG. 6. In this case, the cell module 1a is composed over a plurality of substrates 2.

In the thin-film solar cell module 1 of this embodiment, when an output from the cell module 1a is P (W), an output from the cell string 21 is Ps (W), and an area of the contact line 17 is Sc (cm²) under a condition of light source: xenon lamp, irradiance: 100 mW/cm², AM: 1.5, temperature: 25°C (hereinafter, referred to as "standard condition"), the power density applied to the contact line (P - Ps) / Sc is 10.7 (kW/cm²) or less, Ps is 12 W or less, and P is 385 W or less (these three conditions will be collectively referred to as "basic condition"). Hereinafter, the term "output" means an output under the standard condition.

It is judged by the following method whether or not the basic condition is satisfied. First, when there are a plurality of cell modules 1a, one arbitrary cell module 1a is selected. Then, one arbitrary cell string 21 in the selected cell module 1a is selected. In addition, when there are a plurality of contact lines 17, one arbitrary contact line 17 in the selected cell string 21 is selected. Then, the selected cell module 1a, cell string 21, and contact line 17 are judged for whether or not the basics condition is satisfied.

The output P of the cell module 1a is preferably 90 W or more, though not particularly limited as long as it is 385 W or less. When the output P of the cell module 1a is 385 W or less and the power density applied to the contact line (P - Ps) / Sc is 10.7 (kW/cm²) or less, damage to the contact line 17 is prevented. In addition, the contact line 17 is more likely to be damaged when the output P of the cell module 1a is 90 W or more, and therefore there will be an increased need for the thin-film solar cell module 1 to be designed to satisfy the basic condition. Specifically, the output P of the cell module 1a is, for example, 50, 60, 70, 80, 90, 100, 110, 120, 130, 140, 150, 160, 170, 180, 190, 200, 210, 220, 230, 240, 250, 260, 270, 280, 290, 300, 310, 320, 330, 340, 350, 360, 370, 380, or 385 W. The output P of the cell module 1a may be not more than any one of the numeral values exemplified here, or may be in a range between any two of the numeral values.

It is preferable that the output Ps of the cell string 21 is small in view of prevention of damage to a cell due to a hotspot phenomenon (for example, peel-off of a film between the surface electrode 3 and the first photoelectric conversion layer 5). The upper limit of the output Ps of the cell string 21 is determined by a cell hotspot resistance test to be described later, and was determined to be 12 W. The output Ps of the cell string 21 is not particularly limited as long as it is 12 W or less, and specific examples thereof include 1, 2, 3, 4, 5, 6, 7, 8, 9, 10, 11, or 12 W. The output Ps of the cell string 21 may be not more than any one of the numeral values exemplified here, or may be in a range between any two of the numeral values. The output Ps of the cell string 21 can be calculated according to: (output P of cell module 1a / area of effective power generation region of cell module 1a) × area of cell string 21.

In order to reduce the output Ps of the cell string 21 when the output P of the cell module 1a is constant, the number of the cell strings 21 included in the cell string 1a should be increased. In order to increase the number of the cell strings 21, the number of parallel division lines 25 should be increased. In other words, the number of parallel division stages of the cell module 1a should be increased. The number of parallel division stages will be the number of parallel division lines 25 + 1.

The more the number of parallel division stages is, the more advantageous, when considering only the upper limit of the output Ps of the cell string 21. However, when the number of parallel division stages is increased, the power density applied to the contact line (P - Ps) /Sc is increased, and the contact line 17 becomes likely to be damaged for the following reasons.

### (1) Increase of power applied from the other cell strings 21

When one cell string 21 is in shade, power generated in all the other cell strings is applied to the cell string 21 in shade. The value of the power to be applied to the cell string 21 in shade will be: (output P of cell module 1a) - (output Ps of cell string 21 in shade). Since the value of (P - Ps) is increased as the value of Ps of the cell string 21 is reduced, the power to be applied to the cell string 21 in shade is increased as the number of parallel division stages is increased to reduce the output Ps of each cell string 21.

### (2) Decrease of area of contact line 17

When the number of parallel division stages is increased, a length L of the contact line 17 illustrated in FIG. 3 (b) is shortened, and, as a result, an area Sc of the contact line 17 is made smaller.

### (3) Increase of power density applied to contact line

As described above, the value of P - Ps is increased, and the area Sc of the contact line 17 is made smaller, when the number of parallel division stages is increased. Therefore, the power density applied to the contact line (P - Ps) /Sc is increased, and the contact line 17 becomes likely to be damaged.

In order to prevent damage to the contact line 17, it is necessary to hold the power density applied to the contact line (P - Ps) /Sc to an upper limit thereof or lower. The upper limit of the power density applied to the contact line (P - Ps) /Sc can be determined according to a reverse overcurrent resistance test to be described later, and was determined to be 10.7 (kW/cm²). The power density applied to the contact line (P - Ps) /Sc is not particularly limited as long as it is 10.7 (kW/cm²) or less, and specific examples thereof include 1, 2, 3, 4, 5, 6, 7, 8, 9, 10, 10.5, or 10.7 (kW/cm²). The power density applied to the contact lines (P - Ps) / Sc may be not more than any one of the numeral values exemplified here, or may be in a range between any two of the numeral values.

In the meantime, the area Sc of the contact line 17 is determined according to: length L of contact line 17 × width W of contact line 17 as illustrate in FIG. 3 (b). Both the length L and the width W of the contact line 17 can be measured by observation from a side of a light incident surface of the cell (side of substrate 2) with the use of an optical microscope.

The width W of the contact line 17 is not particularly limited, and it is, for example, 20 µm to 300 µm, preferably 40 µm to 200 µm. As the width W of the contact line 17 is decreased, the area Sc is decreased and the power density applied to the contact line (P - Ps) / Sc is increased. As the width W of the contact line 17 is increased, the area of the effective power generation region is decreased. Therefore, when the width W of the contact line 17 is 40 µm to 200 µm, the power density applied to the contact line (P - Ps) / Sc will not be increased too much and a larger area of the effective power generation region can be ensured. Specifically, the width W of the contact line 17 is, for example, 20, 30, 40, 50, 60, 70, 80, 90, 100, 110, 120, 130, 140, 150, 160, 170, 180, 190, 200, 210, 220, 230, 240, 250, 260, 270, 280, 290, or 300 µm. The width W of the contact line 17 may be in a range between any two of the numeral values exemplified here.

### 2. Plasma CVD apparatus

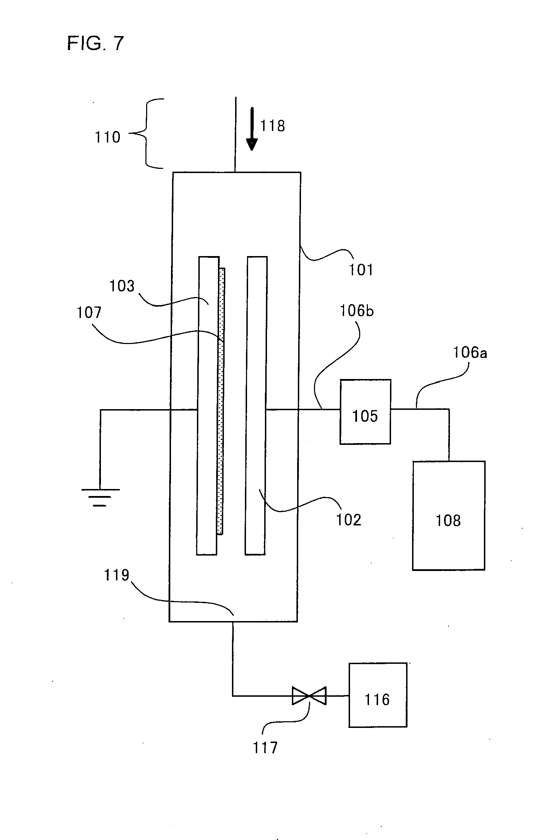

Next, a plasma CVD apparatus for forming a semiconductor layer included in the above-described thin-film solar cell module will be described by use of FIG. 7. FIG. 7 is a sectional view illustrating a structure of a plasma CVD apparatus to be used for production of the thin-film solar cell module according to the present embodiment.

The structure illustrated in FIG. 7 is an exemplification, and the semiconductor layer may be formed by use of an apparatus of another structure. In addition, the semiconductor layer may be formed by a method other than plasma CVD. Here, a plasma CVD apparatus of a single chamber type having one film forming chamber will be described as an example, but the description is also true for a plasma CVD apparatus of a multi-chamber type having a plurality of film forming chambers.

As shown in FIG. 7, the plasma CVD apparatus used in this embodiment includes: a film forming chamber 101 for forming a semiconductor layer therein, which can be hermetically sealed; a gas intake section 110 for introducing a replacement gas into the film forming chamber 101; and a gas exhaust section 116 for evacuating the replacement gas from the film forming chamber 101.

More specifically, the plasma CVD apparatus shown in FIG. 7 has a parallel plate-type electrode structure in which a cathode electrode 102 and an anode electrode 103 are installed in the film forming chamber 101 capable of being hermetically sealed. The distance between the cathode electrode 102 and the anode electrode 103 is determined depending on desired treatment conditions, and it is generally several millimeters to several tens of millimeters. A power supply section 108 for supplying electric power to the cathode electrode 102 and an impedance matching circuit 105 for matching impedances among the power supply section 108, the cathode electrode 102, and the anode electrode 103 are installed outside the film forming chamber 101.

The power supply section 108 is connected to one end of a power introducing line 106a. The other end of the power introducing line 106a is connected to the impedance matching circuit 105. One end of a power introducing line 106b is connected to the impedance matching circuit 105, and the other end of the power introducing line 106b is connected to the cathode electrode 102. The power supply section 108 may output either of a CW (continuous waveform) alternating current output or a pulse-modulated (on/off control) alternating current output, or may be one capable of switching these outputs to output.

The frequency of the alternating electric power outputted from the power supply section 108 is generally 13.56 MHz, but it is not limited thereto, and frequencies of several kHz to VHF band and a microwave band may be used.

On the other hand, the anode electrode 103 is electrically grounded, and a substrate 107 is located on the anode electrode 103. The substrate 107 is, for example, the substrate 2 on which the surface electrode 3 is formed. The substrate 107 may be placed on the cathode electrode 102, but it is generally placed on the anode electrode 103 in order to reduce degradation of film quality due to ion damage in plasma.

The gas intake section 110 is provided in the film forming chamber 101. A gas 118 such as a dilution gas, a material gas, and a doping gas is introduced from the gas intake section 110. Examples of the dilution gas include a gas including a hydrogen gas. Examples of the material gas include a silane base gas, a methane gas, a germane gas, and the like. Examples of the doping gas include a doping gas of a p-type impurity such as a diborane gas, and a doping gas of an n-type impurity such as a phosphine gas.

Further, the gas exhaust section 116 and a pressure control valve 117 are connected in series to the film forming chamber 101, and the gas pressure in the film forming chamber 101 is kept approximately constant. It is desirable that the gas pressure is measured at a position away from the gas intake section 110 and a gas exhaust outlet 119 in the film forming chamber, because measurement of the gas pressure at a position close to the gas intake section 110 and the gas exhaust outlet 119 causes errors somewhat. By supplying electric power to the cathode electrode 102 under this condition, it is possible to generate plasma between the cathode electrode 102 and the anode electrode 103 to decompose the gas 118, and to form the semiconductor layer on the substrate 107.

The gas exhaust section 116 may be one capable of evacuating the film forming chamber 101 to reduce the gas pressure in the film forming chamber 101 to a high vacuum of approximately 1.0 × 10⁻⁴ Pa, but it may be one having an ability for evacuating gases in the film forming chamber 101 to a pressure of approximately 0.1 Pa in view of simplification of an apparatus, cost reduction, and an increase in throughput. The volume of the film forming chamber 101 has been getting larger as the size of the substrate of the semiconductor device grows. When such a film forming chamber 101 is highly evacuated to a vacuum, a high-performance gas exhaust section 116 is required, and therefore it is not desirable from the viewpoint of simplification of an apparatus and cost reduction, and it is more desirable to use a simple gas exhaust section 116 for a low vacuum.

Examples of the simple gas exhaust section 116 for a low vacuum include a rotary pump, a mechanical booster pump, a sorption pump, and the like, and it is preferable to use these pumps alone or in combination of two or more kinds thereof.

The film forming chamber 101 of the plasma CVD apparatus used in this embodiment can be sized in approximately 1 m³, for example. As a typical gas exhaust section 116, a mechanical booster pump and a rotary pump connected in series can be used.

### 3. Method for producing thin-film solar cell module

Next, a method for producing the thin-film solar cell module according to an embodiment of the present invention will be described by use of FIG. 1, FIG. 2, FIGs. 3 (a) (b), and FIG. 7.

Hereinafter, the method will be described taking, as an example, the case of forming the semiconductor layer by use of a plasma CVD apparatus of a single chamber type having one film forming chamber as shown in Fig. 7, but the following description is basically also true for the case of forming the semiconductor layer by use of a plasma CVD apparatus of a multi-chamber type. However, with the plasma CVD apparatus of a multi-chamber type, a gas replacement step to be described later can be omitted, because the p-type, the i-type, and the n-type semiconductor layers can be formed in different film forming chambers.

In the production method of this embodiment, the first photoelectric conversion layer 5, the second photoelectric conversion layer 7, and the third photoelectric conversion layer 9 are formed in the same film forming chamber. To form the photoelectric conversion layers in the same film forming chamber means that the first, second, and third photoelectric conversion layers 5, 7, 9 are formed by use of the same electrode or different electrodes in the same film forming chamber, and it is desirable that the first, second, and third photoelectric conversion layers 5, 7, 9 are formed by use of the same electrode in the same film forming chamber. Further, it is desirable from the viewpoint of improving production efficiency that the first, second, and third photoelectric conversion layers 5, 7, 9 are successively formed without being released to the air on the way. Furthermore, it is desirable from the viewpoint of improving production efficiency that substrate temperatures during the formation of the first, second, and third photoelectric conversion layers 5, 7, 9, are the same.

Hereinafter, a method for producing the thin-film solar cell module 1 will be described in detail. The method to be described below is exemplification, and the thin-film solar cell module 1 may be produced by a method other than the method to be described below.

### 3-1. Step of forming surface electrode

First, the surface electrode 3 is formed on the substrate 2.

As the substrate 2, a glass substrate and a substrate of a resin such as polyimide and the like which have heat resistance and a light transmitting property in a plasma CVD forming process, can be used.

As the surface electrode 3, transparent conductive films formed of a material containing SnO₂ and the like can be used. They may be formed by a method such as a CVD method, a sputtering method, and a vapor deposition method.

### 3-2. Step of forming surface electrode division line

Next, the surface electrode division line 13 extending in an X direction in FIG. 1 (in a direction of a longer side of the substrate 2; in a direction in which the plurality of cell strings 21 in the cell module 1a are arranged) is formed on the surface electrode 3, thereby dividing the surface electrode 3 into a pattern of a plurality of band-like shapes. The surface electrode division line 13 may be formed by, for example, scribing the surface electrode 3 by use of a fundamental wave of a YAG laser.

### 3-3. Step of forming first photoelectric conversion layer

Next, the first photoelectric conversion layer 5 is formed on the obtained substrate. As described above, since the first photoelectric conversion layer 5 has the p-type semiconductor layer 5a, the buffer layer 5b, the i-type amorphous layer 5c, and the n-type semiconductor layer 5d, the respective semiconductor layers are formed in order.

A gas replacement step of replacing the inside of the film forming chamber 101 with a replacement gas is performed to reduce the concentration of impurities in the film forming chamber 101 before the formation of the p-type semiconductor layer 5a (that is, before the formation of the first photoelectric conversion layer 5) and before the formation of the i-type amorphous layer 5c. Since the impurities introduced in the preceding step or the impurities immixed from the outside when a substrate is carried into the film forming chamber 101 remain in the film forming chamber 101, quality of the semiconductor layer is deteriorated if the semiconductor layer takes in the impurities. Therefore, the concentration of the impurities in the film forming chamber 101 is reduced in advance. The gas replacement step is also performed before the formation of the p-type semiconductor layer 7a (that is, before the formation of the second photoelectric conversion layer 7), before the formation of the i-type amorphous layer 7c, before the formation of the p-type semiconductor layer 9a (that is, before the formation of the third photoelectric conversion layer 9), and before the formation of the i-type microcrystalline layer 9b. Here, each gas replacement step may be performed under the same condition, or under different conditions.

In addition, when the plasma CVD apparatus of a multi-chamber type is used, the concentration of the impurities in the film forming chamber can be reduced by changing the film forming chamber in place of performing the gas replacement step. In general, the p-type semiconductor layer 5a and the buffer layer 5b are formed in a first film forming chamber, the i-type amorphous layer 5c is formed in a second film forming chamber, and the n-type semiconductor layer 5d is formed in a third film forming chamber. Further, the p-type semiconductor layer 7a, the buffer layer 7b, and the p-type semiconductor layer 9a are formed in the first film forming chamber, the i-type amorphous layer 7c and the i-type microcrystalline layer 9b are formed in the second film forming chamber, and the n-type semiconductor layer 7d and the n-type semiconductor layer 9c are formed in the third film forming chamber. The p-type amorphous layer and the buffer layer may be formed in different film forming chambers.
Hereinafter, a step of forming the first photoelectric conversion layer 5 will be described in detail.

### 3-3 (1) Gas replacement step

The substrate 2 on which the surface electrode 3 is formed is installed in the film forming chamber 101, and thereafter the gas replacement step of replacing the inside of the film forming chamber 101 with a replacement gas is performed. This gas replacement step is performed to reduce the concentration of the impurities which are immixed from the outside of the film forming chamber 101 in carrying a substrate to be provided with a semiconductor layer into the film forming chamber 101. Further, when the thin-film solar cell module is produced repeatedly, the first to third photoelectric conversion layers are formed repeatedly, and therefore the n-type semiconductor layer 9c of the third photoelectric conversion layer 9, previously formed, is deposited on an inner wall, an electrode, and the like in the film forming chamber 101. Therefore, it will be a problem that impurities released from the n-type semiconductor layer 9c of the third photoelectric conversion layer 9, particularly impurities that determine a conductive type of the n-type semiconductor layer 9c of the third photoelectric conversion layer 9, are immixed in the p-type semiconductor layer 5a of the first photoelectric conversion layer 5. Accordingly, the gas replacement step is performed before the formation of the p-type semiconductor layer 5a to reduce the amount of n-type impurities to be immixed in the p-type semiconductor layer 5a.

Thereby, a semiconductor layer of good quality can be formed as the p-type semiconductor layer 5a of the first photoelectric conversion layer 5. Here, since the p-type semiconductor layer 5a generally includes p-type conductive impurities in a concentration of approximately 1 × 10²⁰ cm⁻³, satisfactory photoelectric conversion characteristics are attained if the concentration of the immixed n-type conductive impurities is approximately 1 × 10¹⁸ cm⁻³ or less, which is 2 digits less than the concentration of the p-type conductive impurities.

The gas replacement step can be performed through an operation cycle in which, for example, a hydrogen gas is introduced into the film forming chamber 101 as a replacement gas (step of introducing a replacement gas), the introduction of the hydrogen gas is stopped when the internal pressure of the film forming chamber 101 reaches a predetermined pressure (for example, approximately 100 Pa to 1000 Pa), and the hydrogen gas is evacuated until the internal pressure of the film forming chamber 101 reaches a predetermined pressure (for example, approximately 1 Pa to 10 Pa) (evacuation step). This cycle may be repeated more than once.

The period of time required to perform the above-mentioned one cycle can be several seconds to several tens of seconds. Specifically, the step of introducing a replacement gas can be performed over 1 to 5 seconds, and the evacuation step can be performed over 30 to 60 seconds. Even when the steps are performed in such a short period of time, the concentration of the impurities in the film forming chamber can be reduced by repeating this cycle more than once. Therefore, the method for producing the thin-film solar cell module according to this embodiment is also practical when it is applied to mass production devices.

In this embodiment, it is preferable that an internal pressure of the film forming chamber 101 after introducing a replacement gas and an internal pressure after evacuating the replacement gas are set in advance. In the step of introducing a replacement gas, the evacuation from the film forming chamber 101 is stopped, and when the internal pressure of the film forming chamber 101 reaches above the internal pressure after introducing the replacement gas, the introduction of the replacement gas is stopped to terminate the step of introducing a replacement gas. In the evacuation step, the introduction of the replacement gas is stopped, and when the internal pressure of the film forming chamber 101 reaches below the internal pressure after evacuating the replacement gas, the evacuation is stopped to terminate the evacuation step.

By increasing the number of repetitions of the cycle, or by decreasing the ratio (M/m) of a pressure M after evacuating the replacement gas to a pressure m after introducing the replacement gas, the concentration of the impurities existing in the film forming chamber 101 can be more reduced.

Further, in this embodiment, the present invention is described taking, as an example, the case where a hydrogen gas is used as a replacement gas, but in another embodiment, any gas usable for formation of an i-type layer, such as a silane gas, may be used as a replacement gas. The gas usable for the formation of the i-type layer are also usable for the formation of any of the p-type, i-type, and n-type semiconductor layers. Accordingly, it is preferable to use a gas used for the formation of the i-type layer as a replacement gas, because in this case, no impurity from this gas is immixed in the semiconductor layer.

Further, in another embodiment, an inert gas or the like, which does not have an effect on film quality of the semiconductor layer may be used as a replacement gas. In particular, a gas having a large atomic weight is apt to remain in the film forming chamber 101 after the evacuation of the inside of the film forming chamber 101 and is suitable for a replacement gas. Examples of the inert gas include an argon gas, a neon gas, a xenon gas, and the like.

Further, the replacement gas may be a mixture gas of any one or more of gases usable for the formation of the i-type layer and one or more inert gases.

### 3-3 (2) Step of forming p-type semiconductor layer

Next, the p-type semiconductor layer 5a is formed. Hereinafter, a step of forming the p-type semiconductor layer 5a will be described.

First, the inside of the film forming chamber 101 can be evacuated to a pressure of 0.001 Pa and the substrate temperature can be set at a temperature of 200°C or lower. Thereafter, the p-type semiconductor layer 5a is formed. A mixture gas is introduced into the film forming chamber 101 and the internal pressure of the film forming chamber 101 is kept approximately constant by a pressure control valve 117 provided in an exhaust system. The internal pressure of the film forming chamber 101 is in a range of, for example, 200 Pa to 3600 Pa. As the mixture gas to be introduced into the film forming chamber 101, for example, a gas including a silane gas, a hydrogen gas, and a diborane gas can be used. Further, the mixture gas can include a gas (for example, methane gas) containing carbon atoms in order to reduce the amount of light absorption. The flow rate of the hydrogen gas can be 5 times or more and 300 times or less larger than that of the silane gas, and it is preferably approximately 5 times to 30 times in the case of forming a p-type amorphous layer, and 30 times to 300 times in the case of forming a p-type microcrystalline layer.

After the internal pressure of the film forming chamber 101 is stabilized, an alternating electric power of several kHz to 80 MHz is inputted to the cathode electrode 102 to generate plasma between the cathode electrode 102 and the anode electrode 103, thereby forming an amorphous or microcrystalline p-type semiconductor layer 5a. The power density per unit area of the cathode electrode 102 is preferably in a range of 0.01 W/cm² to 0.3 W/cm² in the case of forming a p-type amorphous layer, and it is preferably in a range of 0.02 W/cm² to 0.5 W/cm² in the case of forming a p-type microcrystalline layer.

Thus, the p-type semiconductor layer 5a having a desired thickness is formed, and then input of the alternating electric power is stopped and the film forming chamber 101 is evacuated to a vacuum.

The thickness of the p-type semiconductor layer 5a is preferably 2 nm or more, more preferably 5 nm or more in terms of providing an adequate internal electric field for the i-type amorphous layer 5c. Further, the thickness of the p-type semiconductor layer 5a is preferably 50 nm or less, more preferably 30 nm or less in terms of necessity for suppressing the amount of light absorption on a side of light entrance of an inactive layer.

### 3-3 (3) Step of forming buffer layer

Next, an i-type amorphous layer is formed as the buffer layer 5b. First, a background pressure in the film forming chamber 101 is evacuated to a vacuum of approximately 0.001 Pa. The substrate temperature can be set at a temperature of 200°C or lower. Next, a mixture gas is introduced into the film forming chamber 101, and the internal pressure of the film forming chamber 101 is kept approximately constant by the pressure control valve 117. The internal pressure of the film forming chamber 101 is adjusted to be in a range of, for example, 200 Pa to 3000 Pa. As the mixture gas to be introduced into the film forming chamber 101, for example, a gas including a silane gas and a hydrogen gas can be used. Further, the mixture gas can include a gas (for example, methane gas) containing carbon atoms in order to reduce the amount of light absorption. Desirably, the flow rate of a hydrogen gas is approximately several times to several tens of times larger than that of a silane gas.

After the internal pressure of the film forming chamber 101 is stabilized, an alternating electric power of several kHz to 80 MHz is inputted to the cathode electrode 102 to generate plasma between the cathode electrode 102 and the anode electrode 103, thereby forming an i-type amorphous layer as the buffer layer 5b. The power density per unit area of the cathode electrode 102 may be in a range of 0.01 W/cm² to 0.3 W/cm².

Thus, the i-type amorphous layer having a desired thickness is formed as the buffer layer 5b, and then input of the alternating electric power is stopped and the inside of the film forming chamber 101 is evacuated to a vacuum.

By forming the i-type amorphous layer as the buffer layer 5b, the concentration of boron atoms in atmosphere in the film forming chamber 101 is reduced to allow reduction of boron atoms to be immixed in the i-type amorphous layer 5c to be formed next.

The thickness of the i-type amorphous layer as the buffer layer 5b is desirably 2 nm or more in order to inhibit diffusion of boron atoms from the p-type semiconductor layer 5a to the i-type amorphous layer 5c. On the other hand, this thickness is desirably as small as possible in order to suppress the amount of light absorption to increase light reaching the i-type amorphous layer 5c. The thickness of the buffer layer 5b is generally adjusted to 50 nm or less.

### 3-3 (4) Gas replacement step

Next, a gas replacement step is performed in the same manner as in "3-3 (1) Gas replacement step".

The p-type semiconductor layer 5a, formed in the preceding step, is deposited on an inner wall and an electrode in the film forming chamber 101. Therefore, it will be a problem that impurities released from the p-type semiconductor layer 5a, particularly impurities that determine a conductive type of the p-type semiconductor layer 5a are immixed in the i-type amorphous layer 5c, but by performing the gas replacement step before the formation of the i-type amorphous layer 5c, the amount of the above-mentioned impurities to be immixed in the i-type amorphous layer 5c can be reduced. Thereby, a semiconductor layer of good quality can be formed as the i-type amorphous layer 5c.

### 3-3 (5) Step of forming i-type amorphous layer

Next, the i-type amorphous layer 5c is formed. First, the background pressure in the film forming chamber 101 is evacuated to a vacuum of approximately 0.001 Pa. The substrate temperature can be set at a temperature of 200°C or lower. Next, a mixture gas is introduced into the film forming chamber 101 and the internal pressure of the film forming chamber 101 is kept approximately constant by the pressure control valve 117. The internal pressure of the film forming chamber 101 is adjusted to be in a range of, for example, 200 Pa to 3000 Pa. As the mixture gas to be introduced into the film forming chamber 101, for example, a gas including a silane gas and a hydrogen gas can be used. The flow rate of the hydrogen gas is preferably approximately several times to several tens of times larger than that of the silane gas, more preferably 5 times or more and 30 times or less. In this case, the i-type amorphous layer 5c of good film quality can be formed.

After the internal pressure of the film forming chamber 101 is stabilized, an alternating electric power of several kHz to 80 MHz is inputted to the cathode electrode 102 to generate plasma between the cathode electrode 102 and the anode electrode 103, thereby forming the i-type amorphous layer 5c. The power density per unit area of the cathode electrode 102 can be in a range of 0. 01 W/cm² to 0.3 W/cm².

Thus, the i-type amorphous layer 5c having a desired thickness is formed, and then input of the alternating electric power is stopped and the inside of the film forming chamber 101 is evacuated to a vacuum.

The thickness of the i-type amorphous layer 5c is preferably set at 0.05 µm to 0.25 µm in consideration of the amount of light absorption and deterioration of photoelectric conversion characteristics due to light degradation.

### 3-3 (6) Step of forming n-type semiconductor layer

Next, the n-type semiconductor layer 5d is formed. First, the background pressure in the film forming chamber 101 is evacuated to a vacuum of approximately 0.001 Pa. The substrate temperature can be set at a temperature of 200°C or lower, for example 150°C. Next, a mixture gas is introduced into the film forming chamber 101 and the internal pressure of the film forming chamber 101 is kept approximately constant by the pressure control valve 117. The internal pressure of the film forming chamber 101 is adjusted to be in a range of, for example, 200 Pa to 3600 Pa. As the mixture gas to be introduced into the film forming chamber 101, a gas including a silane gas, a hydrogen gas, and a phosphine gas can be used. The flow rate of the hydrogen gas can be 5 times or more and 300 times or less larger than that of the silane gas, and it is preferably approximately 5 times to 30 times in the case of forming an n-type amorphous layer, and 30 times to 300 times in the case of forming an n-type microcrystalline layer.

After the internal pressure of the film forming chamber 101 is stabilized, an alternating electric power of several kHz to 80 MHz is inputted to the cathode electrode 102 to generate plasma between the cathode electrode 102 and the anode electrode 103, thereby forming an amorphous or microcrystalline n-type semiconductor layer 5d. The power density per unit area of the cathode electrode 102 is preferably in a range of 0.01 W/cm² to 0.3 W/cm² in the case of forming an n-type amorphous layer, and it is preferably in a range of 0.02 W/cm² to 0.5 W/cm² in the case of forming an n-type microcrystalline layer.

The thickness of the n-type semiconductor layer 5d is preferably 2 nm or more in order to provide an adequate internal electric field for the i-type amorphous layer 5c. On the other hand, the thickness of the n-type semiconductor layer 5d is preferably as small as possible in order to suppress the amount of light absorption in the n-type semiconductor layer 5d as an inactive layer, and it is generally adjusted to 50 nm or less.

Thus, the first photoelectric conversion layer 5 including the i-type amorphous layer 5c can be formed.

### 3-4. Step of forming second photoelectric conversion layer

Next, the second photoelectric conversion layer 7 is formed on the obtained substrate. As described above, the second photoelectric conversion layer 7 has the p-type semiconductor layer 7a, the buffer layer 7b, the i-type amorphous layer 7c, and the n-type semiconductor layer 7d, and the respective semiconductor layers are therefore formed in order.
Hereinafter, a step of forming the second photoelectric conversion layer 7 will be described in detail.

### 3-4 (1) Gas replacement step

Next, a gas replacement step is performed in the same manner as in "3-3 (1) Gas replacement step". By performing this gas replacement step, it is possible to reduce the amount of impurities released from the n-type semiconductor layer deposited on an inner wall and an electrode in the film forming chamber 101 during the formation of the n-type semiconductor layer 5d, particularly impurities that determine a conductive type of the n-type semiconductor layer 5d to be immixed in the p-type semiconductor layer 7a. Thereby, a semiconductor layer of good quality can be formed as the p-type semiconductor layer 7a. Here, since the p-type semiconductor layer 7a includes p-type conductive impurities in a concentration of approximately 1 × 10²⁰ cm⁻³, satisfactory photoelectric conversion characteristics are attained if the concentration of immixed n-type conductive impurities is approximately 1 × 10¹⁸ cm⁻³ or less, which is 2 digits less than the concentration of the p-type conductive impurities.

### 3-4 (2) Step of forming p-type semiconductor layer

Next, the p-type semiconductor layer 7a is formed. The p-type semiconductor layer 7a can be formed in the same manner as in the formation of the p-type semiconductor layer 5a of the first photoelectric conversion layer 5.

### 3-4 (3) Step of forming buffer layer

Next, the buffer layer 7b is formed in the same manner as in the formation of the buffer layer 5b of the first photoelectric conversion layer 5.

### 3-4 (4) Gas replacement step

Next, a gas replacement step is performed in the same manner as in "3-3 (1) Gas replacement step". In this gas replacement step, an effect identical or similar to that in the gas replacement step performed before the formation of the i-type amorphous layer 5c of the first photoelectric conversion layer 5 can be attained.

### 3-4 (5) Step of forming i-type amorphous layer

Next, the i-type amorphous layer 7c is formed.

The thickness of the i-type amorphous layer 7c is preferably set at 0.1 µm to 0.7 µm in consideration of the amount of light absorption and deterioration of the photoelectric conversion characteristics due to light degradation.

Further, it is desirable that the bandgap of the i-type amorphous layer 7c of the second photoelectric conversion layer 7 is narrower than the bandgap of the i-type amorphous layer 5c of the first photoelectric conversion layer 5. This is because, by forming such a bandgap, light of wavelength band that the first photoelectric conversion layer 5 cannot absorb can be absorbed in the second photoelectric conversion layer 7, and incident light can be utilized effectively.

In order to narrow the bandgap of the i-type amorphous layer 7c, the substrate temperature during the film formation can be set at a higher temperature. By increasing the substrate temperature, the concentration of hydrogen atoms contained in the film can be reduced and an i-type amorphous layer 7c having a small bandgap can be formed. That is, it is only necessary to adopt a substrate temperature for the formation of the i-type amorphous layer 7c of the second photoelectric conversion layer 7 higher than the substrate temperature for the formation of the i-type amorphous layer 5c of the first photoelectric conversion layer 5. Thereby, it is possible to make the concentration of hydrogen atoms in the i-type amorphous layer 5c of the first photoelectric conversion layer 5 higher than the concentration of hydrogen atoms in the i-type amorphous layer 7c of the second photoelectric conversion layer 7 and to produce a stacked thin-film solar cell module in which the bandgap of the i-type amorphous layer 5c of the first photoelectric conversion layer 5 is wider than the bandgap of the i-type amorphous layer 7c of the second photoelectric conversion layer 7.

Further, by decreasing the flow rate ratio of a hydrogen gas to a silane gas of a mixture gas to be introduced into the film forming chamber 101 in the formation of the i-type amorphous layer 7c, the concentration of hydrogen atoms contained in the i-type amorphous layer 7c can be reduced and the i-type amorphous layer 7c having a narrow bandgap can be formed. That is, it is only necessary to adopt a flow rate ratio of the hydrogen gas to the silane gas of the mixture gas in the formation of the i-type amorphous layer 7c of the second photoelectric conversion layer 7 smaller than that in the formation of the i-type amorphous layer 5c of the first photoelectric conversion layer 5. Thereby, it is possible to make the concentration of hydrogen atoms in the i-type amorphous layer 5c of the first photoelectric conversion layer 5 higher than the concentration of hydrogen atoms in the i-type amorphous layer 7c of the second photoelectric conversion layer 7 and to produce a stacked thin-film solar cell module in which the bandgap of the i-type amorphous layer 5c of the first photoelectric conversion layer 5 is wider than the bandgap of the i-type amorphous layer 7c of the second photoelectric conversion layer 7.

Furthermore, it is also possible to adjust the bandgap of the i-type amorphous layer by selecting either forming the i-type amorphous layer by continuous discharge plasma or forming the i-type amorphous layer by pulse discharge plasma. When the i-type amorphous layer is formed by continuous discharge plasma, the concentration of hydrogen atoms contained into the i-type amorphous layer to be formed can be made higher than that in the case of forming the i-type amorphous layer by pulse discharge plasma.

Accordingly, it is possible to produce a stacked thin-film solar cell module in which the bandgap of the i-type amorphous layer 5c of the first photoelectric conversion layer 5 is wider than the bandgap of the i-type amorphous layer 7c of the second photoelectric conversion layer 7 by switching supply electric power for generating plasma so that the i-type amorphous layer 5c of the first photoelectric conversion layer 5 can be formed by continuous discharge plasma and the i-type amorphous layer 7c of the second photoelectric conversion layer 7 can be formed by pulse discharge plasma.

The setting of the substrate temperatures for the formation of the i-type amorphous layer 5c of the first photoelectric conversion layer 5 and the i-type amorphous layer 7c of the second photoelectric conversion layer 7, the setting of the flow rate ratio of the hydrogen gas to the silane gas, and the setting of the switching between the continuous discharge and the pulse discharge may be done separately, or the respective settings may be used in combination. In particular, when the substrate temperatures for the formation of the i-type amorphous layer 5c of the first photoelectric conversion layer 5 and the i-type amorphous layer 7c of the second photoelectric conversion layer 7 are the same, concurrent use of the setting of the flow rate ratio of the hydrogen gas to the silane gas and the switching between the continuous discharge and the pulse discharge is desirable, because it allows the concentration of hydrogen atoms contained in the i-type amorphous layer to be changed by a large amount.

### 3-4 (6) Step of forming n-type semiconductor layer

Next, the n-type semiconductor layer 7d is formed. The n-type semiconductor layer 7d can be formed in the same manner as in the formation of the n-type semiconductor layer 5d of the first photoelectric conversion layer 5.

### 3-5. Step of forming third photoelectric conversion layer

Next, the third photoelectric conversion layer 9 is formed on the obtained substrate. As described above, the third photoelectric conversion layer 9 has the p-type semiconductor layer 9a, the i-type microcrystalline layer 9b, and the n-type semiconductor layer 9c, and the respective semiconductor layers are therefore formed in order.
Hereinafter, a step of forming the third photoelectric conversion layer 9 will be described in detail.

### 3-5 (1) Gas replacement step

First, a gas replacement step is performed in the same manner as in "3-3 (1) Gas replacement step". This gas replacement step has an effect identical or similar to that in the gas replacement step performed before the formation of the second photoelectric conversion layer 7.

### 3-5 (2) Step of forming p-type semiconductor layer

Next, the p-type semiconductor layer 9a is formed. The p-type semiconductor layer 9a can be formed in the same manner as in the formation of the p-type semiconductor layer 5a of the first photoelectric conversion layer 5.

### 3-5 (3) Gas replacement step

Next, a gas replacement step is performed in the same manner as in "3-3 (1) Gas replacement step". This gas replacement step has an effect identical or similar to that in the gas replacement step performed before the formation of the i-type amorphous layer 5c of the first photoelectric conversion layer 5 and the i-type amorphous layer 7c of the second photoelectric conversion layer 7.

### 3-5 (4) Step of forming i-type microcrystalline layer

Next, the i-type microcrystalline layer 9b is formed. The i-type microcrystalline layer 9b can be formed, for example, under the following formation conditions. The substrate temperature is desirably set at a temperature of 200°C or lower. The internal pressure of the film forming chamber 101 during the formation of the layer is desirably in a range of 240 Pa to 3600 Pa. Further, the power density per unit area of the cathode electrode 102 is desirably set to be in a range of 0.02 W/cm² to 0.5 W/cm².

As a mixture gas to be introduced into the film forming chamber 101, for example, a gas including a silane gas and a hydrogen gas may be used. The flow rate of the hydrogen gas is desirably approximately 30 times to several hundreds of times larger than that of the silane gas, more desirably approximately 30 times to 300 times.

The thickness of the i-type microcrystalline layer 9b is preferably 0.5 µm or more, more preferably 1 µm or more in order to secure an adequate amount of light absorption. On the other hand, the thickness of the i-type microcrystalline layer 9b is preferably 20 µm or less, more preferably 15 µm or less in order to secure good productivity.

Thus, an i-type microcrystalline layer 9b having a good crystallinity, in which the intensity ratio I₅₂₀/I₄₈₀) of a peak at 520 nm⁻¹ to a peak at 480 nm⁻¹, measured by Raman spectroscopy, is in a range of 3 to 10 can be formed.

### 3-5 (5) Step of forming n-type semiconductor layer

Next, the n-type semiconductor layer 9c is formed. The n-type semiconductor layer 9c can be formed in the same manner as in the formation of the n-type semiconductor layer 5d of the first photoelectric conversion layer 5.

### 3-6. Step of forming photoelectric conversion layer division line

Next, the photoelectric conversion layer division line 15 is formed in the first to third photoelectric conversion layers 5, 7, 9 so as to extend in the X direction in FIG. 1 and so as to be off the position of the surface electrode division line 13, thereby dividing the first to third photoelectric conversion layers 5, 7, 9 into a pattern of a plurality of band-like shapes. The photoelectric conversion layer division line 15 can be formed by scribing the first to third photoelectric conversion layers 5, 7, 9 by use of second higher harmonics of a YAG laser, for example.

Since the contact line 17 is formed by filling the photoelectric conversion layer division line 15 with an electrical conductor (for example, material of the back surface electrode), the width of the photoelectric conversion layer division line 15 and the width of the contact line 17 agree.

### 3-7. Step of forming back surface electrode

Next, the back surface electrode 11 is formed on the third photoelectric conversion layer 9. The back surface electrode 11 has a transparent conductive film and a metal film in this order from a side of the third photoelectric conversion layer 9, and these films are therefore formed in order.

The transparent conductive film is formed of SnO₂, ITO, ZnO, or the like. The metal film is formed of a metal such as silver and aluminum. The transparent conductive film and the metal film are formed by a method such as a CVD method, a sputtering method, and a vapor deposition method. The transparent conductive film may be omitted.

When the back surface electrode 11 is formed, a material of the back surface electrode 11 gets into the photoelectric conversion layer division line 15 to form the contact line 17.

### 3-8. Step of forming back surface electrode division line

Next, the back surface electrode division line 29 extending in the X direction in FIG. 1 is formed in the back surface electrode 11 and the first to third photoelectric conversion layers 5, 7, 9, thereby dividing the back surface electrode 11 and the first to third photoelectric conversion layers 5, 7, 9 into a pattern of a plurality of band-like shapes. The back surface electrode division line 29 is formed so that the three lines 13, 15, 29 are arranged in order of the surface electrode division line 13, the photoelectric conversion layer division line 15, and the back surface electrode division line 29.

The back surface electrode division line 29 can be formed by scribing the back surface electrode 11 and the first to third photoelectric conversion layers 5, 7, 9 by use of second higher harmonics of a YAG laser, for example.

Through the steps that have been described so far, the band-shaped cell string 21 having the plurality of cells 27 connected to each other in series is obtained.

### 3-9. Step of forming parallel division line

Next, the parallel division line 25 extending in a Y direction in FIG. 1 (in a direction of a shorter side of the substrate 2; in a direction in which the plurality of cells 27 in the cell string 21 are arranged) in the band-shaped cell string 21, thereby dividing the band-shaped cell string 21 into a plurality of cell strings 21.

The parallel division line 25 can be formed by scribing the back surface electrode 11 and the first to third photoelectric conversion layers 5, 7, 9 by use of second higher harmonics of a YAG laser, for example, and by further scribing the surface electrode 3 by use of a fundamental wave of a YAG laser.

### 3-10. Step of forming common electrode

Next, the common electrode 23 is installed so that the plurality of cell strings 21 are connected to each other in parallel to complete production of the thin-film solar cell module 1 of this embodiment.

### 4. Cell hotspot resistance test

A cell hotspot resistance test was performed by the following method.
First, a large number of samples having the same configuration (except that there is no parallel division line 25 and no common electrode 23) as that of the thin-film solar cell module of the embodiment described above with reference to FIG. 1, FIG. 2, FIG. 3 (a), and FIG. 3 (b) were produced by using materials shown in Table 1. The number of series connection stages of each sample was 30.

**Table 1**

| Element | | Material |
|---|---|---|
| Substrate 2 | | Glass |
| First electrode 3 | | SnO2 (projection-and-recess shape on surface) |
| First photoelectric conversion layer 5 | P-type semiconductor layer 5a (amorphous layer) | Amorphous silicon carbide |
| | Buffer layer 5b | Amorphous silicon carbide |
| | I-type amorphous layer 5c | Amorphous silicon |
| | N-type semiconductor layer 5d (amorphous layer) | Amorphous silicon |
| Second photoelectric conversion layer 7 | P-type semiconductor layer 7a (amorphous layer) | Amorphous silicon carbide |
| | Buffer layer 7b | Amorphous silicon carbide |
| | I-type amorphous layer 7c | Amorphous silicon |
| | N-type semiconductor layer 7d (amorphous layer) | Amorphous silicon |
| Third photoelectric conversion layer 9 | P-type semiconductor layer 9a (microcrystalline layer ) | Microcrystalline silicon |
| | I-type microcrystalline layer 9b | Microcrystalline silicon |
| | N-type semiconductor layer 9c (microcrystalline layer ) | Microcrystalline silicon |
| Second electrode 11 | Transparent conductive film | ZnO |
| | Metal film | Ag |

Each sample produced was measured for an I-V property and an RB current (a current when a voltage of 5 V to 8 V was applied in a reverse direction; the voltage applied was appropriately varied so that the RB current values shown in Table 2 were obtained).

Next, samples that are different from one another in RB current were selected out of the above-described samples. Each of the selected samples was divided in parallel, thereby obtaining a 5 W to 50 W of output of the cell string 21 being evaluated.

Next, the hotspot resistance test was performed on a cell 27 having the smallest area in the cell string 21 for judgment of acceptance with defining a peeled area of less than 5% as an acceptance line. The hotspot resistance test was performed in accordance with ICE 61646 1st EDITION. The acceptance line was made severer in terms of an aim to make the appearance better, while the acceptance line of IEC61646 1st EDITION is 10%. As the peeled area, a surface of the sample was photographed from the side of the substrate 2, the contrast of an obtained image was increased to obtain a monochrome image, and a percentage of the area accounted for by the white part in this image was calculated. Since a part that experienced peel-off of a film usually has a larger luminance, the percentage of the area of the white part obtained in the above-described manner corresponds to the percentage of the area of the part that experienced peel-off of a film (peeled area).

Table 2 shows a result obtained. Table 2 shows the result of the measurement of 54 types of samples that are different from one another in output of the cell string 21 or RB current for the peeled area.

**Table 2**

| | | | | | | | | | |
|---|---|---|---|---|---|---|---|---|---|
| Output from entire sample (W) | 85 | 84 | 100 | 120 | 100 | 90 | 120 | 90 | 100 |
| Number of parallel division stages (number of cell strings) | 17 | 12 | 10 | 10 | 5 | 3 | 3 | 2 | 2 |
| Output from cell string→ RB current↓ | 5 W | 7W | 10 W | 12 W | 20 W | 30 W | 40 W | 45 W | 50 W |
| 0.019 mA/cm² | 0.1% | 0.2% | 1.5% | 2.3% | 3.5% | 4.1% | 4.8% | 5.5% | 6.2% |
| 0.084 mA/cm² | 0.8% | 1.0% | 1.7% | 2.5% | 3.9% | 4.6% | 5.1% | 5.8% | 6.5% |
| 0.31 mA/cm² | 0.9% | 1.5% | 2.1% | 4.5% | 5.1% | 6.5% | - | - | - |
| 2.06 mA/cm² | 1.0% | 1.7% | 2.6% | 4.8% | 5.8% | 7.2% | - | - | - |
| 2.29 mA/cm² | 0.7% | 1.0% | 1.7% | 2.6% | 4.1% | 4.8% | 5.3% | 5.8% | 6.4% |
| 6.44 mA/cm² | 0.1% | 0.1% | 1.2% | 2.3% | 3.7% | 4.1% | 4.5% | 5.2% | 5.8% |

Table 2 has revealed that the samples are unlikely to experience peel-off of a film in both the case where the magnitude of the RB current is very small (0.019 mA/cm²) and the case where the magnitude of the RB current is very large (6.44 mA/cm²), and the samples are likely to experience peel-off of a film in the case where the magnitude of the RB current is moderate (0.31 to 2.06 mA/cm²), even if the output from the cell string 21 is the same.

It has been also revealed that the peeled area can be held to 5% or less regardless of the value of the RB current, when the output from the cell string is 12 W or less.

### 5. Reverse overcurrent resistance test

Next, a reverse overcurrent resistance test was performed in the following manner. First, samples having the same configuration as that of the thin-film solar cell module of the embodiment described above with reference to FIG. 1, FIG. 2, FIG. 3 (a), and FIG. 3 (b) were produced by using materials shown in Table 1. The number of series connection stages of each sample was 30.
Next, the reverse overcurrent resistance test was performed by examining whether or not the contact line 17 was damaged when an overcurrent was applied to the produced samples in a reverse direction (the reverse direction referred to means a direction opposite to a direction in which a current passes when the solar cell is in light, that is, it would be a forward direction in the case where the solar cell not in light is considered a diode).

According to the provisions of IEC 61730, the current to be applied here needs to be 1.35 times the anti-overcurrent specification value, and was set to 5.5 A at 70 V here.

Here, when a current is applied to one cell module under the above-described condition, it is apt to be considered that the current will be divided equally to be applied to each cell string connected in parallel. Actually, however, the current can be concentrated in a particular cell string, because the resistance value varies from string to string. On the assumption that this is the worst case situation, problems must be prevented from occurring even when 70 V × 5.5 A = 385 W is applied to one cell string. Therefore, a power of 70 V × 5.5 A = 385 W was applied to one cell string 21 to carry out the test.

Samples of 20 types that are different from one another in length L or width W of the contact line 17 were produced to carry out the test. It was judged by visual observation whether or not the contact line 17 was damaged. The contact line 17 was judged to have been damaged when there was discoloring or peel-off in the back surface electrode 11 in a half oval shape along the contact line 21. Table 3 shows a result obtained.

**Table 3**

| Length L of contact line (cm)→ Width of contact line W↓ | 37.5 | 30 | 22.5 | 18 | 15 | 12.9 | 11.3 | 10 | 9 | 8.2 |
|---|---|---|---|---|---|---|---|---|---|---|
| 20 µm | ○ | ○ | ○ | ○ | × | × | × | × | × | × |
| 40 µm | ○ | ○ | ○ | ○ | ○ | ○ | ○ | ○ | ○ | × |

Table 3 has revealed that when the width W of the contact line 17 is 20 µm and 40 µm, damage to the contact line 17 can be prevented by setting the length L of the contact line 17 to 18 cm or more and 9 cm or more, respectively. In other words, it has been revealed that the area Sc of the contact line 17 should be 20 µm × 18 cm or more, or 40 µm × 9 cm = 0.036 cm² or more.

Furthermore, it has been revealed that (power applied to cell string 21) / (area Sc of contact line 17) ≅ 10.7 kW/cm², because the power applied to the cell string 21 was 385 W, and therefore damage to the contact line 17 can be prevented when the power density applied to the contact line 21 is 10.7 kW/cm² or less.

## Claims

1. A thin-film solar cell module which is **characterized in that** it provides:
a cell module having a plurality of cell strings bidirectionally connected to each other in parallel, the cell strings each having a plurality of cells connected to each other in series via a contact line, the cells each having a surface electrode, a photoelectric conversion layer, and a back surface electrode stacked in this order, the contact line electrically connecting the surface electrode of one of two neighboring cells of the cells and the back surface electrode of the other,
wherein when an output from the cell module is P (W), an output from one of the cell strings is Ps (W), and an area of the contact line is Sc (cm²) under a condition of light source: xenon lamp, irradiance: 100 mW/cm², AM: 1.5, and temperature: 25°C, (P - Ps) / Sc is 10.7 (kW/cm²) or less, Ps is 12 W or less, and P is 385 W or less.

2. The module according to Claim 1, wherein P is 90 W or more.

3. The module according to Claim 1, wherein the contact line has a width in a range of 40 µm to 200 µm.

4. The module according to Claim 1, wherein the surface electrode is formed of a transparent conductive film formed of a material containing SnO₂, and the back surface electrode has a layered structure of a transparent conductive film and a metal film.
